# EUROPEAN PATENT APPLICATION

(11) **EP 4 007 161 A1**
(43) Date of publication of application: **01.06.2022**
(21) Application number: 21209574.9
(22) Date of filing: 22.11.2021
(51) Int. Cl.: H03B 5/32, H03B 21/01, H03L 7/06

(54) **CLOCK OSCILLATOR AND METHOD FOR PREPARING CLOCK OSCILLATOR**

(30) Priority: 30.11.2020 CN 202011386723; 10.02.2021 CN 202110183763
(71) Applicant: Huawei Technologies Co., Ltd., Shenzhen, Guangdong 518129 (CN)
(72) Inventor: Wang, Jinhui, Shenzhen, Guangdong, 518129 (CN); Wu, Wei, Shenzhen, Guangdong, 518129 (CN); Zeng, Xiaoyi, Shenzhen, Guangdong, 518129 (CN); Huang, Xinhua, Shenzhen, Guangdong, 518129 (CN)
(74) Representative: Grünecker Patent- und Rechtsanwälte PartG mbB

(57) **Abstract**

A clock oscillator, a method for preparing the clock oscillator, a method for using the clock oscillator, and a chip that includes the clock oscillator are provided. The clock oscillator includes a first resonator, a second resonator, and a frequency synthesis module, where an output frequency of the first resonator is higher than an output frequency of the second resonator, the frequency synthesis module is configured to generate a synthesis frequency based on the output frequency of the first resonator and the output frequency of the second resonator, and the synthesis frequency is used as a clock frequency output by the clock oscillator. The clock oscillator uses both of the two resonators with the different output frequencies as clock signal sources, and generates a synthesized clock signal by using the frequency synthesis module. In this way, one clock oscillator is used to meet requirements of a plurality of ICT clock application scenarios, thereby reducing device complexity and production costs.

## Description

### TECHNICAL FIELD

This application relates to the computer field, and in particular, to a clock oscillator capable of generating a plurality of output frequencies, a method for preparing the clock oscillator, a method for using the clock oscillator, and a chip and an electronic device that include the clock oscillator.

### BACKGROUND

A clock oscillator is an important component in an electronic system and provides necessary clock frequencies for the electronic system, so that the electronic system can perform various operations at the clock frequencies to implement normal operation. The clock oscillator generally includes modules such as an electrical/mechanical resonator, a feedback network, an amplification network, and an output network. Frequency selection is implemented by using a resonance characteristic of the electrical/mechanical resonator, to generate a frequency signal that periodically oscillates, namely, a clock signal.

An information and communication technology (Information and Communication Technology, ICT) may involve different clock application scenarios, and the different application scenarios have different requirements for the clock signal. The existing clock oscillator cannot simultaneously meet different requirements. As a result, a plurality of different clock oscillators need to be simultaneously configured to meet the foregoing two requirements. This increases device complexity and has high costs.

### SUMMARY

A clock oscillator is provided, and the clock oscillator can meet requirements of different clock application scenarios.

According to a first aspect, a clock oscillator is provided. The clock oscillator includes a first resonator, a second resonator, and a frequency synthesis module. An output frequency of the first resonator is higher than an output frequency of the second resonator. The frequency synthesis module is configured to generate a synthesis frequency based on the output frequency of the first resonator and the output frequency of the second resonator, where the synthesis frequency is used as a clock frequency output by the clock oscillator.

The clock oscillator uses both of the two resonators with the different output frequencies as clock signal sources, and generates a synthesized clock signal by using the frequency synthesis module. In this way, one clock oscillator is used to meet requirements of a plurality of ICT clock application scenarios, thereby reducing device complexity and production costs.

In a possible implementation, the output frequency of the first resonator belongs to a first frequency range, and the output frequency of the second resonator belongs to a second frequency range. The first frequency range is higher than a first frequency value, and the second frequency range is lower than or equal to the first frequency value; or the first frequency range is higher than or equal to a first frequency value, and the second frequency range is lower than the first frequency value. The first frequency value is greater than or equal to 10⁷ Hz and less than or equal to 10⁸ Hz. That is, the first frequency range and the second frequency range are separated by using the first frequency value, and the first frequency range is higher than the second frequency range.

In a possible implementation, the output frequency of the first resonator belongs to a first frequency range, and the output frequency of the second resonator belongs to a second frequency range. The first frequency range is higher than or equal to a first frequency value, the second frequency range is lower than or equal to a second frequency value, and the first frequency value is higher than the second frequency value. That is, there is a frequency band between the first frequency range and the second frequency range.

In other words, the output frequency of the first resonator may belong to a high-frequency range and has a low-jitter characteristic, and the output frequency of the second resonator may belong to a low-frequency range and has a high-stability characteristic. In this way, the generated synthesis frequency has both the low-jitter characteristic and the high-stability characteristic.

In a possible implementation, the frequency synthesis module includes a phase detector, a loop filter, and a tuned circuit. The phase detector generates a control signal by using the loop filter to adjust the tuned circuit.

In a possible implementation, the frequency synthesis module further includes a frequency divider, wherein the frequency divider is connected to the tuned circuit, and is configured to implement multi-frequency output. Therefore, a clock signal that passes through the frequency divider may be further applicable to a clock application scenario requiring a plurality of frequencies.

In a possible implementation, the first resonator and the second resonator are crystal resonators, or the first resonator and the second resonator are semiconductor resonators.

In a possible implementation, the first resonator is an AT-cut crystal resonator, and the second resonator is a stress compensated SC-cut crystal resonator; or the first resonator is a bulk acoustic wave (BAW) resonator, and the second resonator is a silicon micro-electromechanical systems (MEMS) resonator.

In a possible implementation, the first resonator and the second resonator are vacuum-packaged resonators. Vacuum packaging can effectively improve reliability and shockproof capabilities of the resonators.

In a possible implementation, the clock oscillator further includes a heating unit and a temperature sensor. In this way, it is ensured that the output frequency of the low-frequency and high-stability resonator has good temperature stability.

In a possible implementation, the heating unit is integrated into the second resonator, and the temperature sensor is integrated into the second resonator or into an integrated circuit (IC). When the temperature sensor and the heating unit are integrated into the low-frequency and high-stability resonator, the low-frequency and high-stability resonator has better temperature measurement performance and temperature control performance. In addition, a plurality of overall packaging manners such as vacuum packaging and plastic packaging can be flexibly supported.

In a possible implementation, the clock oscillator further includes a temperature control circuit, the temperature control circuit is configured to generate a control signal based on a measurement result of the temperature sensor, and the control signal is used to control the heating unit to generate heat, to adjust a temperature inside the clock oscillator.

According to a second aspect, a method for preparing a clock oscillator is provided. The method includes: obtaining a first resonator and a second resonator, where an output frequency of the first resonator is higher than an output frequency of the second resonator; and packaging the first resonator, the second resonator, and a frequency synthesis module as a whole to obtain the clock oscillator, where the frequency synthesis module is configured to generate a synthesis frequency based on the output frequency of the first resonator and the output frequency of the second resonator, and the synthesis frequency is used as an output clock signal of the clock oscillator.

In a possible implementation, the output frequency of the first resonator belongs to a first frequency range, and the output frequency of the second resonator belongs to a second frequency range. The first frequency range is higher than a first frequency value, and the second frequency range is lower than or equal to the first frequency value; or the first frequency range is higher than or equal to a first frequency value, and the second frequency range is lower than the first frequency value. The first frequency value is greater than or equal to 10⁷ Hz and less than or equal to 10⁸ Hz.

In a possible implementation, the output frequency of the first resonator belongs to a first frequency range, and the output frequency of the second resonator belongs to a second frequency range. The first frequency range is higher than or equal to a first frequency value, the second frequency range is lower than or equal to a second frequency value, and the first frequency value is higher than the second frequency value. That is, there is a frequency band between the first frequency range and the second frequency range.

In a possible implementation, the frequency synthesis module includes a phase detector, a loop filter, and a tuned circuit, where the phase detector generates a control signal by using the loop filter to adjust the tuned circuit.

In a possible implementation, the frequency synthesis module further includes a frequency divider, wherein the frequency divider is connected to the tuned circuit, and is configured to implement multi-frequency output.

In a possible implementation, the first resonator and the second resonator are crystal resonators, or the first resonator and the second resonator are semiconductor resonators.

In a possible implementation, the first resonator is an AT-cut crystal resonator, and the second resonator is a stress compensated SC-cut crystal resonator; or the first resonator is a bulk acoustic wave (BAW) resonator, and the second resonator is a silicon micro-electromechanical systems (MEMS) resonator.

In a possible implementation, the obtaining a first resonator and a second resonator includes: respectively performing vacuum packaging on the first resonator and the second resonator.

In a possible implementation, the obtaining a first resonator and a second resonator includes: integrating a heating unit and a temperature sensor into the second resonator.

In a possible implementation, the obtaining a first resonator and a second resonator includes: integrating the heating unit into the second resonator. The method further includes: integrating the temperature sensor into an integrated circuit (IC). The packaging the first resonator and the second resonator as a whole to obtain the clock oscillator includes: packaging the first resonator, the second resonator, and the IC as a whole.

In a possible implementation, the clock oscillator further includes a temperature control circuit, the temperature control circuit is configured to generate a control signal based on a measurement result of the temperature sensor, and the control signal is used to control the heating unit to generate heat, to adjust a temperature inside the clock oscillator.

According to a third aspect, a method for obtaining a clock frequency is provided, where the method is applied to a clock oscillator. The clock oscillator includes a first resonator and a second resonator. The method includes: obtaining an output frequency of the first resonator and an output frequency of the second resonator, where the output frequency of the first resonator is higher than the output frequency of the second resonator; and generating a synthesis frequency based on the output frequency of the first resonator and the output frequency of the second resonator, where the synthesis frequency is used as a clock frequency output by the clock oscillator.

In a possible implementation, the output frequency of the first resonator belongs to a first frequency range, and the output frequency of the second resonator belongs to a second frequency range. The first frequency range is higher than a first frequency value, and the second frequency range is lower than or equal to the first frequency value; or the first frequency range is higher than or equal to a first frequency value, and the second frequency range is lower than the first frequency value. The first frequency value is greater than or equal to 10⁷ Hz and less than or equal to 10⁸ Hz.

In a possible implementation, the output frequency of the first resonator belongs to a first frequency range, and the output frequency of the second resonator belongs to a second frequency range. The first frequency range is higher than or equal to a first frequency value, the second frequency range is lower than or equal to a second frequency value, and the first frequency value is higher than the second frequency value. That is, there is a frequency band between the first frequency range and the second frequency range.

According to a fourth aspect, a chip is provided, where the chip includes the clock oscillator in any one of the first aspect or the possible implementations of the first aspect.

According to a fifth aspect, an electronic device is provided, where the electronic device includes the clock oscillator in any one of the first aspect or the possible implementations of the first aspect.

In a possible implementation, the electronic device is a communication device or a network device.

According to a sixth aspect, a clock signal is provided, where the clock signal is generated by the clock oscillator in any one of the first aspect or the possible implementations of the first aspect.

### BRIEF DESCRIPTION OF DRAWINGS

To describe technical solutions of this application more clearly, the following briefly describes accompanying drawings used in embodiments. It is clearly that the accompanying drawings in the following description are merely accompanying drawings in some embodiments of this application, and a person of ordinary skill in the art can derive other technical solutions and accompanying drawings of this application from these accompanying drawings without creative efforts.
FIG. 1 is a schematic diagram of a basic principle of a clock oscillator according to an embodiment of this application;
FIG. 2 is a schematic diagram of a structure of a crystal oscillator according to an embodiment of this application;
FIG. 3a is a schematic diagram of a structure of a semiconductor resonator according to an embodiment of this application;
FIG. 3b is a schematic diagram of a structure of a semiconductor oscillator according to an embodiment of this application;
FIG. 4 is a schematic diagram of a working principle of a frequency synthesizer according to an embodiment of this application;
FIG. 5 is a schematic diagram of a structure of a frequency synthesizer according to an embodiment of this application;
FIG. 6 is a schematic diagram of a structure of a clock oscillator according to an embodiment of this application;
FIG. 7a is a schematic diagram of cutting a crystal according to an embodiment of this application;
FIG. 7b is a schematic diagram of a structure of an SMD ceramic-packaged crystal resonator according to an embodiment of this application;
FIG. 8a is a schematic diagram of a structure of a crystal oscillator according to an embodiment of this application;
FIG. 8b is a schematic diagram of a structure of a crystal oscillator according to an embodiment of this application;
FIG. 9a is a schematic diagram of a structure of a semiconductor oscillator according to an embodiment of this application;
FIG. 9b is a schematic diagram of a structure of a semiconductor oscillator according to an embodiment of this application;
FIG. 10a is a schematic diagram of a structure of a semiconductor oscillator according to an embodiment of this application;
FIG. 10b is a schematic diagram of a structure of a semiconductor oscillator according to an embodiment of this application;
FIG. 10c is a schematic diagram of a structure of a semiconductor oscillator according to an embodiment of this application; and
FIG. 11 is a flowchart of a method for preparing a clock oscillator according to an embodiment of this application.

### DESCRIPTION OF EMBODIMENTS

The following describes embodiments of this application with reference to accompanying drawings.

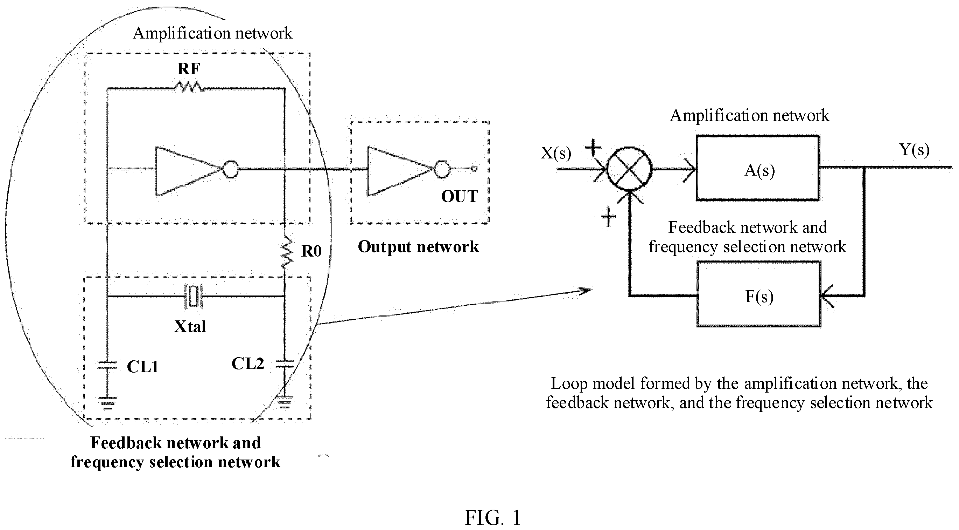

FIG. 1 is a schematic diagram of a basic principle of a clock oscillator. As shown on the left side of FIG. 1, the clock oscillator includes a resonator, a feedback network, a frequency selection network, an amplification network, and an output network. With reference to a loop model formed by the amplification network, the feedback network, and the frequency selection network on the right side of FIG. 1, the amplification network has a power gain; and when the resonator starts to oscillate, the amplification network works in a linear region, to amplify a noise signal or an input signal. Once oscillation of the resonator has been established, the amplification network enters a non-linear state; and a gain of the loop model decreases, to stabilize an amplitude and a frequency of the loop model. The frequency selection network selects each frequency signal output by the amplification network, so that a frequency signal at a selected frequency is output and a signal at another frequency is suppressed. The feedback network feeds back the frequency signal passing through the frequency selection network to an input end of the amplification network to form a closed-loop positive feedback network. The output network shapes and drives the amplified stable frequency signal and outputs the signal to another component.

Lock oscillators may be classified into different types based on differences of the resonators. A crystal oscillator and a semiconductor oscillator are two typical mechanical oscillators.

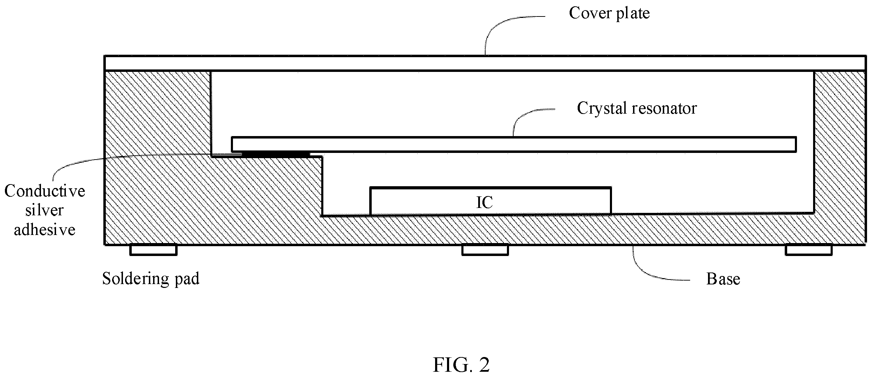

FIG. 2 is a schematic diagram of a structure of a crystal oscillator. As shown in FIG. 2, the crystal oscillator includes a crystal resonator, an integrated circuit (IC), conductive silver adhesive, a base, and a cover plate. The crystal resonator is usually a thin slice cut from a quartz crystal at a specific azimuth, and the crystal resonator is also referred to as a wafer or crystal oscillator. The wafer is semi-suspended in the crystal oscillator, and the crystal oscillator uses a resonant characteristic of the wafer to implement frequency selection and output a signal at a specific frequency. The output frequency may also be referred to as a fundamental frequency (fundamental frequency) of the wafer, or a fundamental frequency for short. Generally, the fundamental frequency of the wafer is related to thickness of the wafer and a method for processing the wafer, and an output frequency of each type of crystal oscillator is a fixed single frequency value. Based on different output frequencies, the crystal oscillators may be classified into a high-fundamental frequency crystal oscillator and a low-fundamental frequency crystal oscillator. In addition, crystal oscillators with different fundamental frequencies have different characteristics, and are applicable to different application scenarios. For example, the high-fundamental frequency oscillator has a relatively high output frequency, and is applicable to an application scenario requiring low jitter. However, output frequency stability of the high-fundamental frequency oscillator is relatively poor, and a shockproof capability and a failure rate of the high-fundamental frequency oscillator are not ideal, in other words, the high-fundamental frequency oscillator cannot be applicable to an application scenario requiring high stability. The low-fundamental frequency oscillator has good output frequency stability, and is applicable to the application scenario requiring high stability. However, jitter performance of the low-fundamental frequency oscillator is poor, in other words, the low-fundamental frequency oscillator cannot be applicable to the application scenario requiring low jitter.

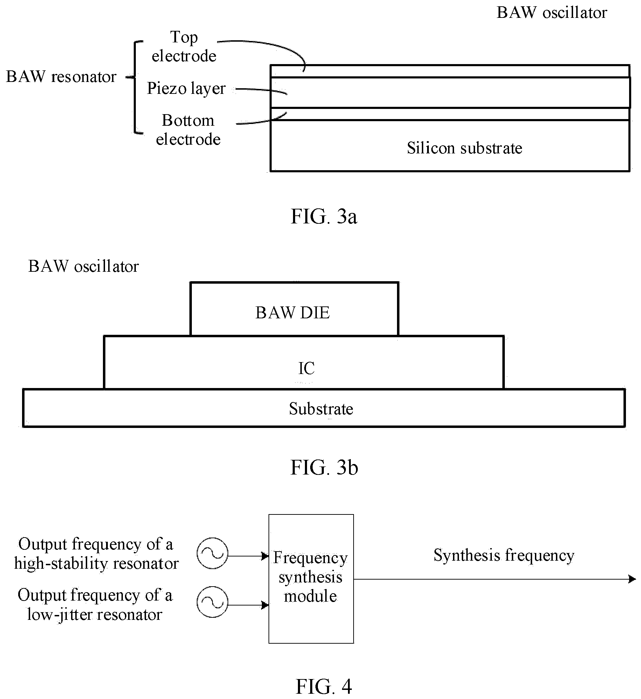

The semiconductor oscillator is another important type of clock oscillator. Compared with the crystal oscillator, a resonator in the semiconductor oscillator is of a micro-nanostructure prepared based on a semiconductor process. Therefore, the semiconductor oscillator is also referred to as a semiconductor resonator. The semiconductor process has advantages of high process precision, a high automation degree, and a high yield rate. The semiconductor resonator within a micron range is usually also a micro-electromechanical systems (Micro-electromechanical Systems, MEMS) resonator. FIG. 3a is a schematic diagram of a structure of a semiconductor resonator, and FIG. 3b shows a semiconductor oscillator including the semiconductor resonator. As shown in FIG. 3a, the semiconductor resonator is a bulk acoustic wave (bulk acoustic wave, BAW) resonator and includes a top electrode, a bottom electrode, a piezo layer, and a substrate. The piezo layer is sandwiched between the top electrode and the bottom electrode, and the whole of the three parts is placed on the substrate. Optionally, an acoustic mirror (acoustic mirror) may be further disposed between the bottom electrode and the substrate. As shown in FIG. 3b, the BAW resonator is connected to an IC circuit and a substrate to form a BAW oscillator. The BAW oscillator is a type of the semiconductor oscillator. A basic principle of the BAW oscillator is to convert an electric signal into an acoustic wave by using an electro-acoustic transducer (not shown in FIG. 4a), and the acoustic wave is transmitted, reflected, and resonated in the piezo layer. Finally, the acoustic wave is converted into a higher-frequency electrical signal to form an oscillation signal.

It should be noted that the semiconductor oscillator in this embodiment of this application may refer to various types of semiconductor oscillators, including but not limited to the BAW oscillator shown in FIG. 3b. Another type of semiconductor oscillator, for example, a silicon MEMS oscillator, is also applicable to this embodiment of this application.

Similar to the crystal oscillator, an output frequency of each type of semiconductor oscillator is also a fixed single frequency value, and each type of semiconductor oscillator is also applicable to a specific application scenario.

It can be learned that currently, there is no oscillator that can simultaneously meet requirements of a plurality of application scenarios. Therefore, to meet requirements of different scenarios, different clock oscillators need to be used. A plurality of clock oscillators need to be configured in a same electronic device, which increases device complexity and has high production costs.

An embodiment of this application provides a clock oscillator. The clock oscillator includes a first resonator, a second resonator, and a frequency synthesis module. An output frequency of the first resonator is higher than an output frequency of the second resonator. The frequency synthesis module is configured to generate a synthesis frequency based on the output frequency of the first resonator and the output frequency of the second resonator, where the synthesis frequency is used as a clock frequency output by the clock oscillator. For example, the first resonator may be a high-fundamental frequency resonator, and the second resonator may be a low-fundamental frequency resonator. In this embodiment of this application, an output frequency range of the low-fundamental frequency resonator may be 0.1 MHz to tens of MHz, and an output frequency range of the high-fundamental frequency resonator may be tens of MHz to several GHz.

The clock oscillator uses both the high-fundamental frequency resonator and the low-fundamental frequency resonator as clock signal sources, and generates a clock signal having both a low-jitter characteristic and a high-stability characteristic by using the frequency synthesis module. In this way, one clock oscillator is used to meet requirements of a plurality of ICT clock application scenarios, thereby reducing device complexity and production costs.

Optionally, the first resonator is a resonator having the high-stability characteristic, and the second resonator is a resonator having the low-jitter characteristic. As shown in FIG. 4, both a high-stability resonator and a low-jitter resonator output signals to a frequency synthesis module, and the frequency synthesis module generates a synthesis frequency. The synthesis frequency is an output signal having both the high-stability characteristic and the low-jitter characteristic, and can meet the requirements of the plurality of clock application scenarios. For example, the high-stability resonator is the low-fundamental frequency resonator, and may also be referred to as a low-frequency and high-stability resonator; and the low-jitter resonator is the high-fundamental frequency resonator, and may also be referred to as a high-frequency and low-jitter resonator. For another example, the high-stability resonator may alternatively be another resonator having the high-stability characteristic, and stability of the resonator is less than one millionth, to be specific, the stability of the resonator is less than 1 ppm. The low-jitter resonator may alternatively be another resonator having the low-jitter characteristic, and jitter of the resonator is less than 100 femtoseconds (fs).

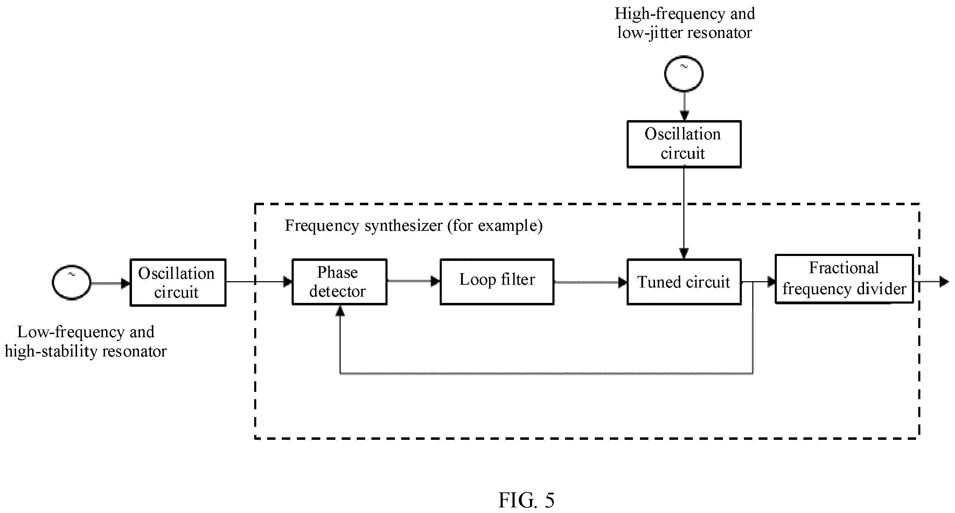

FIG. 5 shows an example implementation form of the frequency synthesis module. As shown in FIG. 5, the output signals of the high-stability resonator and the low-jitter resonator are respectively output to the frequency synthesis module after passing through an oscillation circuit. The frequency synthesis module may include a phase detector, a loop filter, and a tuned circuit. The low-jitter resonator outputs a low-jitter clock signal by using the oscillation circuit, and the high-stability resonator outputs a low-frequency and high-stability clock signal by using the oscillation circuit. The low-jitter clock signal is referenced by the clock signal of the high-stability resonator, and a frequency error of the low-jitter clock signal is identified by using the phase detector. Then, a control signal is generated by using the loop filter to adjust the tuned circuit, so that a clock signal output by the tuned circuit has both the low-jitter characteristic and the high-stability characteristic.

Optionally, the frequency synthesis module further includes a frequency divider, and the frequency divider is connected to the tuned circuit. For example, the frequency divider may be a fractional frequency divider. The clock signal output by the tuned circuit implements multi-frequency output by using the subsequently-cascading fractional frequency divider. Therefore, a clock signal that passes through the frequency divider may be further applicable to a clock application scenario requiring a plurality of frequencies.

Optionally, the clock oscillator further includes a heating unit, a temperature sensor, and a temperature control circuit. The temperature control circuit is configured to generate a control signal based on a measurement result of the temperature sensor, and the control signal is used to control the heating unit to generate heat, to adjust a temperature inside the clock oscillator. For example, the temperature sensor may be a thermistor or a resonator. For another example, the temperature control circuit may convert an output signal of the temperature sensor into a digital signal by using an analog-to-digital converter (analog-to-digital converter, ADC), to control the heating unit. For another example, the heating unit is a MEMS Joule heater.

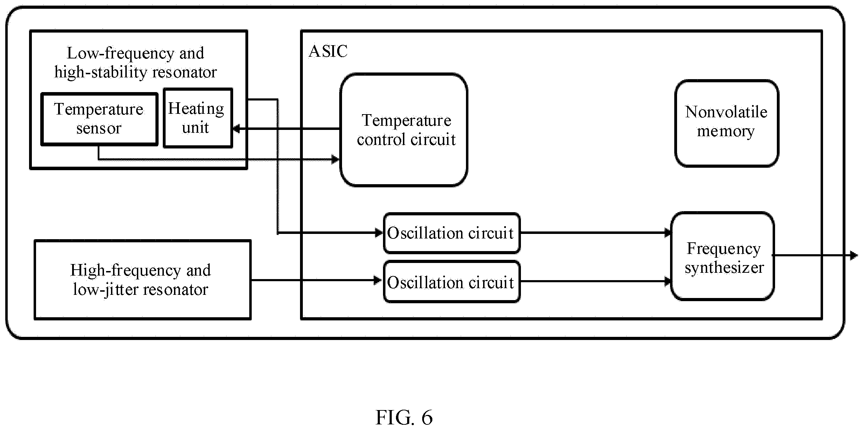

Optionally, the high-stability resonator may be an oven controlled (Oven Controlled) resonator. For example, FIG. 6 shows a possible implementation of a clock oscillator according to an embodiment of this application. The clock oscillator includes a high-stability resonator and a low-jitter resonator, and the clock oscillator further includes a heating unit, a temperature sensor, and a temperature control circuit. The temperature sensor and the heating unit may be integrated into the high-stability resonator. The temperature sensor measures a temperature inside the high-stability resonator. The temperature control circuit generates a control signal based on a measurement result of the temperature sensor, where the control signal is used to control the heating unit to generate heat, to adjust the temperature inside the high-stability resonator and ensure that an output frequency of the high-stability resonator has good temperature stability. When the temperature sensor and the heating unit are integrated into the high-stability resonator, the high-stability resonator has better temperature measurement performance and temperature control performance. In addition, a plurality of overall packaging manners such as vacuum packaging and plastic packaging can be flexibly supported.

Optionally, the temperature sensor may also be integrated into an integrated circuit (IC) of the clock oscillator, to measure a temperature inside the entire clock oscillator.

Optionally, vacuum packaging is respectively performed on the high-stability resonator and the low-jitter resonator, so that reliability and a shockproof capability of the resonator can be effectively improved. Then, the high-stability resonator and the low-jitter resonator that are respectively vacuum-packaged are packaged as a whole to obtain the clock oscillator.

Optionally, the clock oscillator obtained through overall packaging may include a substrate and a cover plate. Optionally, electrical connection or signal interworking can be implemented between the resonator and a base. Optionally, the clock oscillator obtained through overall packaging may further include a soldering pad, configured to implement electrical connection or signal interworking between the resonator and an external component. A quantity of soldering pads is not limited.

Optionally, the clock oscillator provided in this embodiment of this application further includes the integrated circuit (IC). The IC may include a frequency synthesis module and the temperature control circuit. Optionally, the IC may further include the temperature sensor. Optionally, the IC may further include an oscillation circuit. The oscillation circuit is used to excite the resonator to generate a periodic signal, and perform frequency selection, amplification and shaping on the signal for output. Optionally, the IC may further include a nonvolatile memory. The nonvolatile memory may be a readable and writable clock memory, and can still store data at a previous time point after a system is restarted or shut down. Electrical connection or signal interworking can be implemented between the IC and the base.

The clock oscillator provided in this embodiment of this application may be a crystal oscillator, or may be a semiconductor oscillator.

When the clock oscillator is the crystal oscillator, the crystal oscillator includes a crystal resonator. The low-frequency and high-stability resonator may be an SC-cut crystal resonator, and the high-frequency and low-jitter resonator may be an AT-cut crystal resonator.

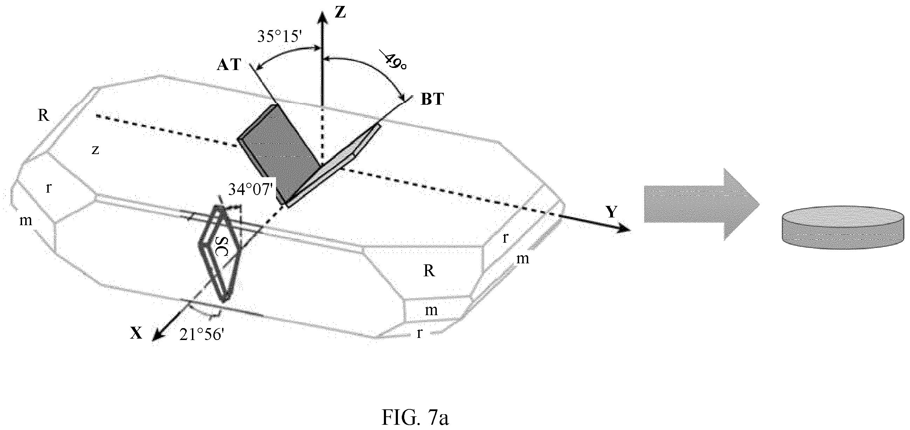

The AT-cut crystal resonator and the SC-cut crystal resonator are different types of crystal resonators that are distinguished based on different cutting angles of crystals. FIG. 7a shows various different cutting angles of the crystals. As described above, the crystal resonator is usually a thin slice cut from a quartz crystal at a specific azimuth. The quartz crystal is a high-purity anisotropic crystal. Based on the different cutting angles, crystal resonators obtained through cutting may be classified into different cutting types. An AT cutting type, a BT cutting type, and an SC cutting type are three common cutting types, and cutting angles of the three cutting types are shown in FIG. 7a.

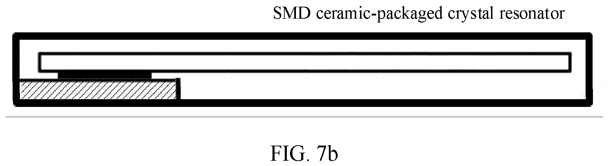

When the high-stability resonator and the low-jitter resonator are crystal resonators, a vacuum packaging manner of the resonator may be surface mounted devices (surface mounted devices, SMD) ceramic packaging. FIG. 7b is a schematic diagram of a structure of an SMD ceramic-packaged crystal resonator. The crystal resonator is semi-suspended, and is bonded to an SMD ceramic-packaged housing by using conductive silver adhesive. Optionally, the SMD ceramic vacuum-packaged crystal resonator can meet various existing general size specifications of the crystal resonator. For example, a packaging size of the SMD ceramic vacuum-packaged crystal resonator may be a differential SMD 3225 or a single-ended SMD 2520.

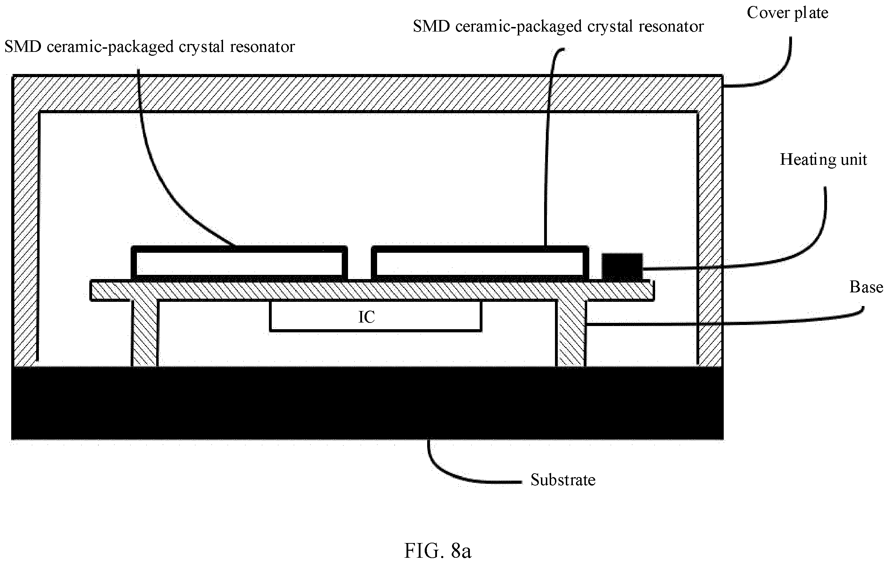

FIG. 8a shows a clock oscillator according to an embodiment of this application. The clock oscillator is a crystal oscillator and includes a high-stability crystal resonator and a low-jitter crystal resonator. The two crystal resonators both use SMD ceramic packaging. The two crystal resonators are placed in parallel on a first surface of a base. A heating unit is further placed on the first surface of the base. An IC is placed on a second surface of the base. The first surface of the base is opposite to the second surface of the base. The IC includes a temperature sensor, a temperature control circuit, and a frequency synthesizer. Optionally, the IC further includes an oscillation circuit and a nonvolatile memory. The foregoing components are packaged as a whole by using a cover plate and a substrate, to form the clock oscillator. Optionally, a soldering pad is further disposed on the substrate, and is not shown in the figure.

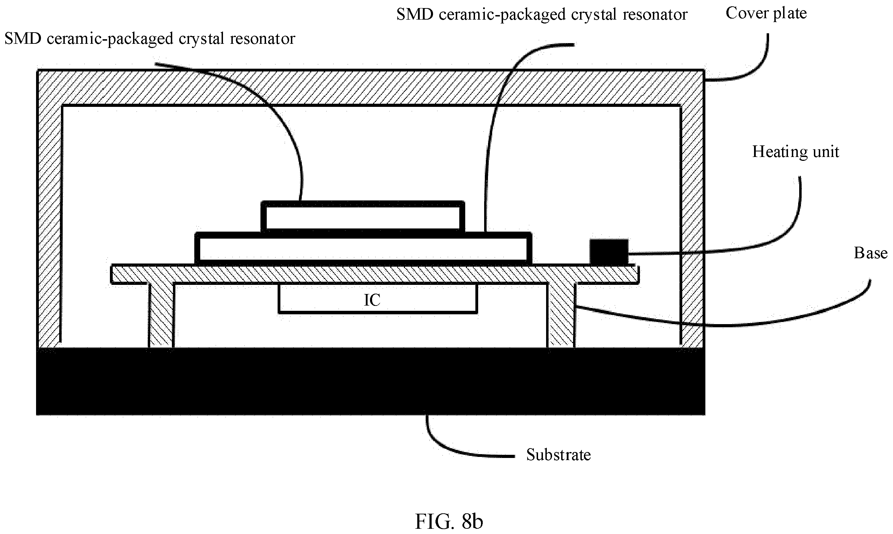

FIG. 8b shows a clock oscillator according to an embodiment of this application. The clock oscillator is a crystal oscillator and includes a high-stability crystal resonator and a low-jitter crystal resonator. The two crystal resonators both use SMD ceramic packaging. The two crystal resonators are superimposed on a first surface of a base. A heating unit is further placed on the first surface of the base. An IC is placed on a second surface of the base. The first surface of the base is opposite to the second surface of the base. The IC includes a temperature sensor, a temperature control circuit, and a frequency synthesizer. Optionally, the IC further includes an oscillation circuit and a nonvolatile memory. The foregoing components are packaged as a whole by using a cover plate and a substrate, to form the clock oscillator. Optionally, a soldering pad is further disposed on the substrate, and is not shown in the figure.

When the clock oscillator is a semiconductor oscillator, the semiconductor oscillator includes a semiconductor resonator. A high-stability resonator may be a silicon MEMS resonator, and a low-jitter resonator may be a BAW resonator. A volume size of the silicon MEMS resonator is very small, and is generally several hundred microns or less.

When the high-stability resonator and the low-jitter resonator are semiconductor resonators, a vacuum packaging manner of the resonators may be wafer packaging.

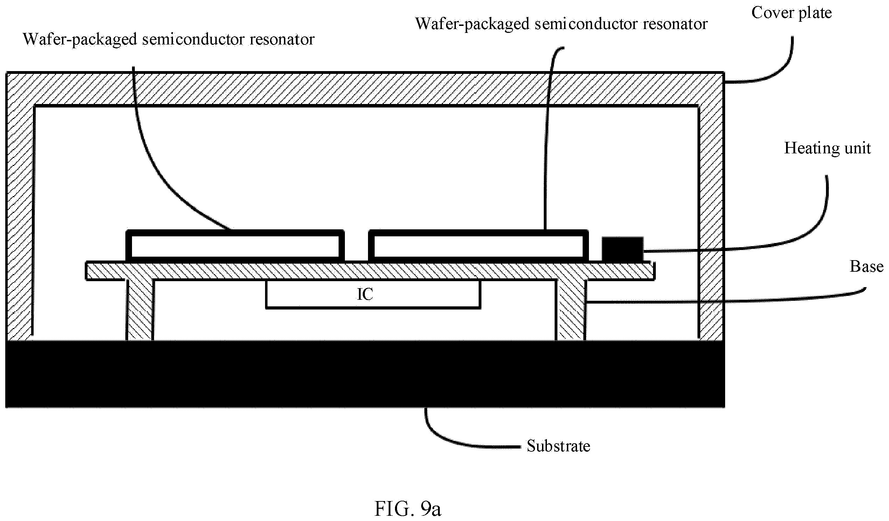

FIG. 9a shows a clock oscillator according to an embodiment of this application. The clock oscillator is a semiconductor oscillator and includes a high-stability silicon MEMS resonator and a low-jitter BAW resonator. The two semiconductor resonators both use wafer packaging. The two semiconductor resonators are placed in parallel on a first surface of a base. A heating unit is further placed on the first surface of the base. An IC is placed on a second surface of the base. The first surface of the base is opposite to the second surface of the base. The IC includes a temperature sensor, a temperature control circuit, and a frequency synthesizer. Optionally, the IC further includes an oscillation circuit and a nonvolatile memory. The foregoing components are packaged as a whole by using a cover plate and a substrate, to form the clock oscillator. Optionally, a soldering pad is further disposed on the substrate, and is not shown in the figure.

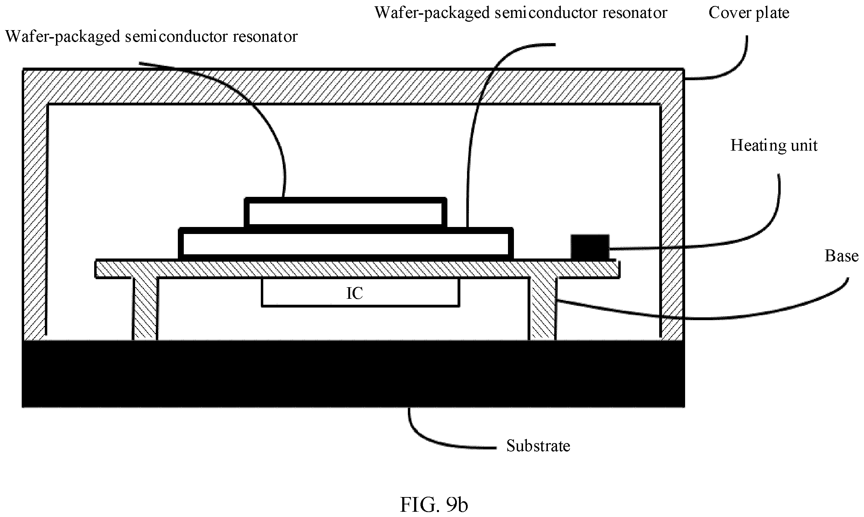

FIG. 9b shows a clock oscillator according to an embodiment of this application. The clock oscillator is a semiconductor oscillator and includes a high-stability silicon MEMS resonator and a low-jitter BAW resonator. The two semiconductor resonators both use wafer packaging. The two semiconductor resonators are superimposed on a first surface of a base. A heating unit is further placed on the first surface of the base. An IC is placed on a second surface of the base. The first surface of the base is opposite to the second surface of the base. The IC includes a temperature sensor, a temperature control circuit, and a frequency synthesizer. Optionally, the IC further includes an oscillation circuit and a nonvolatile memory. The foregoing components are packaged as a whole by using a cover plate and a substrate, to form the clock oscillator. Optionally, a soldering pad is further disposed on the substrate, and is not shown in the figure.

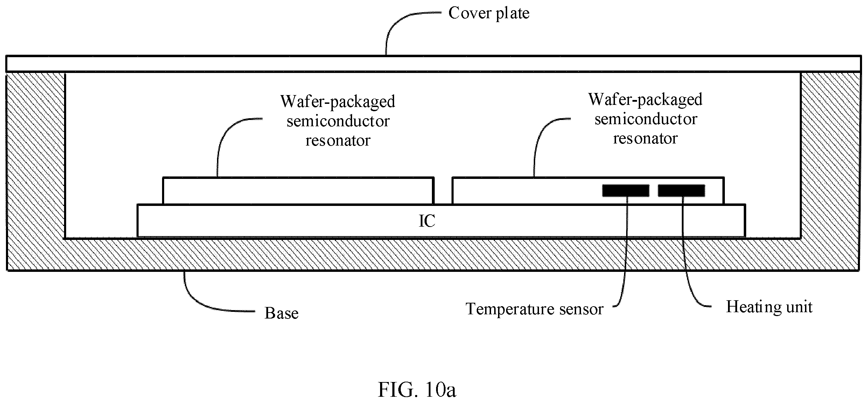

FIG. 10a shows a clock oscillator according to an embodiment of this application. The clock oscillator is a semiconductor oscillator and includes a high-stability silicon MEMS resonator and a low-jitter BAW resonator. The two semiconductor resonators both use wafer packaging. The two semiconductor resonators are placed in parallel on a first surface of a base. The silicon MEMS resonator is further integrated with a temperature sensor and a heating unit. An IC is placed on a second surface of the base. The first surface of the base is opposite to the second surface of the base. The IC includes a temperature control circuit and a frequency synthesizer. Optionally, the IC further includes an oscillation circuit and a nonvolatile memory. The foregoing components are packaged as a whole by using a cover plate and the base, to form the clock oscillator. Optionally, a soldering pad is further disposed on the base, and is not shown in the figure.

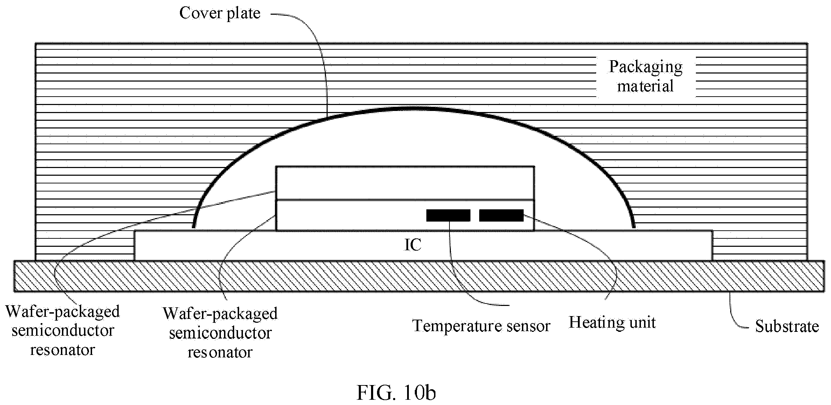

FIG. 10b shows a clock oscillator according to an embodiment of this application. The clock oscillator is a semiconductor oscillator and includes a high-stability silicon MEMS resonator and a low-jitter BAW resonator. The two semiconductor resonators both use wafer packaging. The two semiconductor resonators are superimposed on a first surface of a substrate. The silicon MEMS resonator is further integrated with a temperature sensor and a heating unit. An IC is placed on a second surface of the base. The first surface of the base is opposite to the second surface of the base. The IC includes a temperature control circuit and a frequency synthesizer. Optionally, the IC further includes an oscillation circuit and a nonvolatile memory. The foregoing components are packaged as a whole by using an arc-shaped cover plate and a substrate, to form the clock oscillator. In addition, the outer side of the arc cover plate is further provided with a plastic packaging material. Optionally, a soldering pad is further disposed on the substrate, and is not shown in the figure.

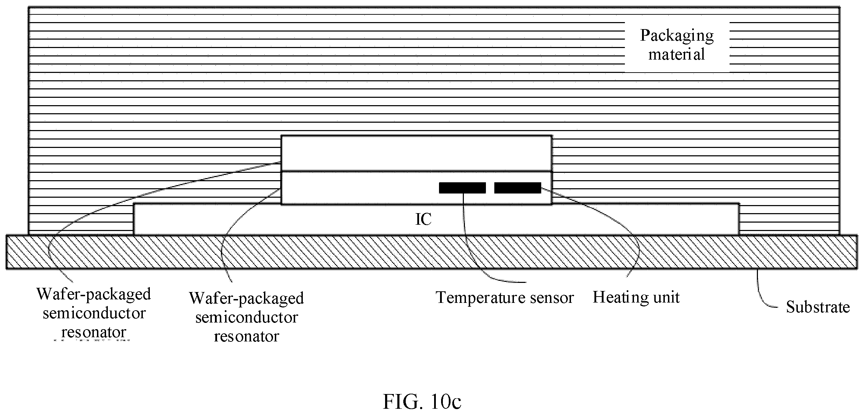

FIG. 10c shows a clock oscillator according to an embodiment of this application. The clock oscillator is a semiconductor oscillator and includes a high-stability silicon MEMS resonator and a low-jitter BAW resonator. The two semiconductor resonators both use wafer packaging. The two semiconductor resonators are superimposed on a first surface of a substrate. The silicon MEMS resonator is further integrated with a temperature sensor and a heating unit. An IC is placed on a second surface of the base. The first surface of the base is opposite to the second surface of the base. The IC includes a temperature control circuit and a frequency synthesizer. Optionally, the IC further includes an oscillation circuit and a nonvolatile memory. The foregoing components are packaged as a whole by using a plastic packaging material and a substrate, to form the clock oscillator. Optionally, a soldering pad is further disposed on the substrate, and is not shown in the figure.

Optionally, in the crystal oscillator and the semiconductor oscillator, an electrode in the vacuum-packaged crystal resonator may be led out in a wire bonding manner, or an electrode in the wafer-packaged semiconductor resonator may be led out in a wire bonding manner.

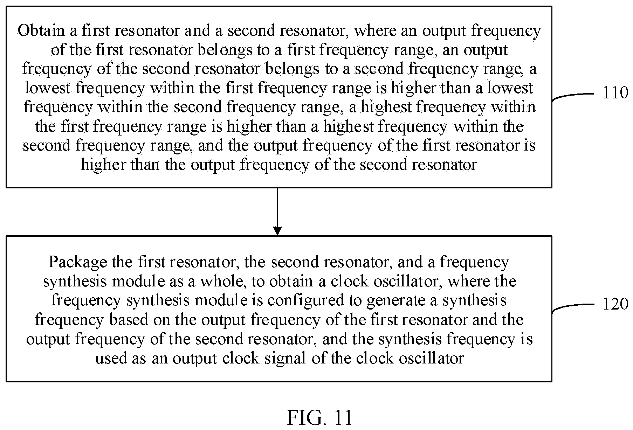

An embodiment of this application provides a method for preparing a clock oscillator. In the method, both a high-fundamental frequency resonator and a low-fundamental frequency resonator are used as clock signal sources, and a clock signal having both a low-jitter characteristic and a high-stability characteristic is generated by using a frequency synthesis module. In this way, one clock oscillator is used to meet requirements of a plurality of ICT clock application scenarios, thereby reducing device complexity and production costs. As shown in FIG. 11, the method includes steps S110 and S120.

S110: Obtain a first resonator and a second resonator, where an output frequency of the first resonator is higher than an output frequency of the second resonator.

S120: Package the first resonator, the second resonator, and a frequency synthesis module as a whole, to obtain the clock oscillator, where the frequency synthesis module is configured to generate a synthesis frequency based on the output frequency of the first resonator and the output frequency of the second resonator, and the synthesis frequency is used as an output clock signal of the clock oscillator.

In a possible implementation, the output frequency of the first resonator belongs to a first frequency range, and the output frequency of the second resonator belongs to a second frequency range. The first frequency range is higher than a first frequency value, and the second frequency range is lower than or equal to the first frequency value; or the first frequency range is higher than or equal to a first frequency value, and the second frequency range is lower than the first frequency value. The first frequency value is greater than or equal to 10⁷ Hz and less than or equal to 10⁸ Hz. That is, the first frequency range and the second frequency range are separated by using the first frequency value, and the first frequency range is higher than the second frequency range.

In a possible implementation, the output frequency of the first resonator belongs to a first frequency range, and the output frequency of the second resonator belongs to a second frequency range. The first frequency range is higher than or equal to a first frequency value, the second frequency range is lower than or equal to a second frequency value, and the first frequency value is higher than the second frequency value. That is, there is a frequency band between the first frequency range and the second frequency range.

Optionally, the frequency synthesis module includes a phase detector, a loop filter, and a tuned circuit, where the phase detector generates a control signal by using the loop filter to adjust the tuned circuit.

Optionally, the frequency synthesis module further includes a frequency divider, wherein the frequency divider is connected to the tuned circuit, and is configured to implement multi-frequency output.

Optionally, the first resonator and the second resonator are crystal resonators, or the first resonator and the second resonator are semiconductor resonators.

Optionally, the first resonator is an AT-cut crystal resonator, and the second resonator is a stress compensated SC-cut crystal resonator; or the first resonator is a bulk acoustic wave (BAW) resonator, and the second resonator is a silicon micro-electromechanical systems (MEMS) resonator.

Optionally, the obtaining a first resonator and a second resonator includes: respectively performing vacuum packaging on the first resonator and the second resonator.

Optionally, the obtaining a first resonator and a second resonator includes: integrating a heating unit and a temperature sensor into the second resonator.

Optionally, the obtaining a first resonator and a second resonator includes: integrating the heating unit into the second resonator. The method further includes: integrating the temperature sensor into an integrated circuit (IC). The packaging the first resonator and the second resonator as a whole to obtain the clock oscillator includes: packaging the first resonator, the second resonator, and the IC as a whole.

Optionally, the clock oscillator further includes a temperature control circuit. The temperature control circuit is configured to generate a control signal based on a measurement result of the temperature sensor, and the control signal is used to control the heating unit to generate heat, to adjust a temperature inside the clock oscillator.

An embodiment of this application provides a method for obtaining a clock frequency. In the method, a clock signal having both a low-jitter characteristic and a high-stability characteristic is obtained by using the clock oscillator in the foregoing embodiments. In this way, one clock oscillator is used to meet requirements of a plurality of ICT clock application scenarios, thereby reducing device complexity and production costs.

An embodiment of this application provides a chip, and the chip includes the clock oscillator in the foregoing embodiments.

An embodiment of this application provides an electronic device, and the electronic device includes the clock oscillator in the foregoing embodiments. Specifically, the electronic device may be a communication device or a network device, for example, a router, a switch, or another forwarding device; the electronic device may be a computer device, for example, a personal computer or a server; or the electronic device may be a communication terminal device, for example, a mobile phone or a wearable intelligent device.

An embodiment of this application provides a chip, and the chip includes the clock oscillator in the foregoing embodiments.

An embodiment of this application provides an electronic device, and the electronic device includes the clock oscillator in the foregoing embodiments. Specifically, the electronic device may be a communication device or a network device, for example, a router, a switch, or another forwarding device; the electronic device may be a computer device, for example, a personal computer or a server; or the electronic device may be a communication terminal device, for example, a mobile phone or a wearable intelligent device.

In the embodiments of this application, terms such as "first" and "second" are used to distinguish same items or similar items that have basically same functions. It should be understood that there is no logical or time sequence dependency between "first", "second", and "n^{th}", and a quantity and an execution sequence are not limited. It should be further understood that although the terms such as first and second are used in the following description to describe various elements, the elements should not be limited by the terms. The terms are merely used to distinguish one element from another element. For example, without departing from the scope of the various examples, a first image may be referred to as a second image, and similarly, a second image may be referred to as a first image. Both the first image and the second image may be images, and in some cases, may be separate and different images.

It should be further understood that sequence numbers of the foregoing processes do not mean execution sequences in various embodiments of this application. The execution sequences of the processes should be determined according to functions and internal logic of the processes, and should not be construed as any limitation on the implementation processes of the embodiments of this application.

It should be understood that the terms used in the description of the various described examples herein are merely intended to describe a particular example, and are not intended for limitation. As used in the description of various such examples and in the appended claims, the singular forms "an" ("a", an")" and "the" are intended to also include plural forms, unless the context otherwise expressly indicates.

It should be further understood that, the term "and/or" used in this specification indicates and includes any or all possible combinations of one or more items in associated listed items. The term "and/or" describes an association relationship for describing associated objects and represents that three relationships may exist. For example, A and/or B may represent the following three cases: Only A exists, both A and B exist, and only B exists. In addition, the character "/" in this application usually indicates an "or" relationship between the associated objects.

It should further be understood that the term "includes" (also referred to as "includes", "including", "comprises", and/or "comprising") used in this specification specifies presence of the stated features, integers, steps, operations, elements, and/or components, with presence or addition of one or more other features, integers, steps, operations, elements, components, and/or their components not excluded.

It should be further understood that the term "if' may be interpreted as a meaning "when" ("when" or "upon"), "in response to determining", or "in response to detecting". Similarly, according to the context, the phrase "if it is determined that" or "if (a stated condition or event) is detected" may be interpreted as a meaning of "when it is determined that" or "in response to determining" or "when (a stated condition or event) is detected" or "in response to detecting (a stated condition or event)".

It should be further understood that "one embodiment", "an embodiment", or "a possible implementation" mentioned throughout this specification means that particular features, structures, or characteristics related to the embodiments or the implementations are included in at least one embodiment of this application. Therefore, "in one embodiment", "in an embodiment", or "in a possible implementation" appearing throughout this specification does not necessarily refer to a same embodiment. In addition, these particular features, structures, or characteristics may be combined in one or more embodiments in any proper manner.

The foregoing descriptions are merely optional implementations of this application, but are not intended to limit the protection scope of this application. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A clock oscillator, wherein the clock oscillator comprises a first resonator, a second resonator, and a frequency synthesis module, wherein
an output frequency of the first resonator is higher than an output frequency of the second resonator; and
the frequency synthesis module is configured to generate a synthesis frequency based on the output frequency of the first resonator and the output frequency of the second resonator, wherein the synthesis frequency is used as a clock frequency output by the clock oscillator.

2. The clock oscillator according to claim 1, wherein the output frequency of the first resonator belongs to a first frequency range, and the output frequency of the second resonator belongs to a second frequency range, wherein
the first frequency range is higher than a first frequency value, and the second frequency range is lower than or equal to the first frequency value; or
the first frequency range is higher than or equal to a first frequency value, and the second frequency range is lower than the first frequency value, wherein
the first frequency value is greater than or equal to 10⁷ Hz and less than or equal to 10⁸ Hz.

3. The clock oscillator according to claim 1, wherein the output frequency of the first resonator belongs to a first frequency range, and the output frequency of the second resonator belongs to a second frequency range, wherein
the first frequency range is higher than or equal to a first frequency value, the second frequency range is lower than or equal to a second frequency value, and the first frequency value is higher than the second frequency value.

4. The clock oscillator according to any one of claims 1 to 3, wherein the frequency synthesis module comprises a phase detector, a loop filter, and a tuned circuit, and the phase detector generates a control signal by using the loop filter to adjust the tuned circuit.

5. The clock oscillator according to claim 4, wherein the frequency synthesis module further comprises a frequency divider, wherein the frequency divider is connected to the tuned circuit, and is configured to implement multi-frequency output.

6. The clock oscillator according to any one of claims 1 to 5, wherein the first resonator and the second resonator are crystal resonators, or the first resonator and the second resonator are semiconductor resonators.

7. The clock oscillator according to claim 6, wherein the first resonator is an AT-cut crystal resonator, and the second resonator is a stress compensated-cut, SC-cut, crystal resonator; or
the first resonator is a bulk acoustic wave, BAW, resonator, and the second resonator is a silicon micro-electromechanical systems, MEMS, resonator.

8. The clock oscillator according to any one of claims 1 to 7, wherein the first resonator and the second resonator are vacuum-packaged resonators.

9. The clock oscillator according to any one of claims 1 to 8, wherein the clock oscillator further comprises a heating unit and a temperature sensor.

10. The clock oscillator according to claim 9, wherein the heating unit is integrated into the second resonator, and the temperature sensor is integrated into the second resonator or into an integrated circuit, IC.

11. The clock oscillator according to claim 9 or 10, wherein the clock oscillator further comprises a temperature control circuit, the temperature control circuit is configured to generate a control signal based on a measurement result of the temperature sensor, and the control signal is used to control the heating unit to generate heat, to adjust a temperature inside the clock oscillator.

12. A method for preparing a clock oscillator, wherein the method comprises:
obtaining a first resonator and a second resonator, wherein an output frequency of the first resonator is higher than an output frequency of the second resonator; and
packaging the first resonator, the second resonator, and a frequency synthesis module as a whole to obtain the clock oscillator, wherein the frequency synthesis module is configured to generate a synthesis frequency based on the output frequency of the first resonator and the output frequency of the second resonator, and the synthesis frequency is used as an output clock signal of the clock oscillator.

13. A method for obtaining a clock frequency, wherein the method is applied to a clock oscillator, the clock oscillator comprises a first resonator and a second resonator, and the method comprises:
obtaining an output frequency of the first resonator and an output frequency of the second resonator, wherein the output frequency of the first resonator is higher than the output frequency of the second resonator; and
generating a synthesis frequency based on the output frequency of the first resonator and the output frequency of the second resonator, wherein the synthesis frequency is used as a clock frequency output by the clock oscillator.

14. The method according to claim 13, wherein the output frequency of the first resonator belongs to a first frequency range, and the output frequency of the second resonator belongs to a second frequency range, wherein
the first frequency range is higher than a first frequency value, and the second frequency range is lower than or equal to the first frequency value; or
the first frequency range is higher than or equal to a first frequency value, and the second frequency range is lower than the first frequency value, wherein
the first frequency value is greater than or equal to 10⁷ Hz and less than or equal to 10⁸ Hz.

15. The method according to claim 13, wherein the output frequency of the first resonator belongs to a first frequency range, and the output frequency of the second resonator belongs to a second frequency range, wherein
the first frequency range is higher than or equal to a first frequency value, the second frequency range is lower than or equal to a second frequency value, and the first frequency value is higher than the second frequency value.

16. A chip, wherein the chip comprises the clock oscillator according to any one of claims 1 to 11.

17. An electronic device, wherein the electronic device comprises the clock oscillator according to any one of claims 1 to 11.
